# EUROPEAN PATENT SPECIFICATION

(11) **EP 2 306 799 B1**
(45) Date of publication and mention of the grant of the patent: **10.10.2018**
(21) Application number: 09762515.6
(22) Date of filing: 10.06.2009
(51) Int. Cl.: H05K 9/00, B32B 9/00, B32B 18/00, B82B 3/00, C01G 23/04, H01F 10/193

(54) **ELECTROMAGNETIC WAVE ABSORBENT MATERIAL**
ELEKTROMAGNETISCHE WELLEN ABSORBIERENDES MATERIAL
MATÉRIAU ABSORBANT D'ONDES ÉLECTROMAGNÉTIQUES

(30) Priority: 10.06.2008 JP 2008151636
(43) Date of publication of application: 06.04.2011
(73) Proprietor: National Institute for Materials Science, Tsukuba-shi, Ibaraki 305-0047 (JP)
(72) Inventor: OSADA Minoru, Tsukuba-shi Ibaraki 305-0047 (JP); SASAKI Takayoshi, Tsukuba-shi Ibaraki 305-0047 (JP)
(74) Representative: Dehns
(86) International application number: PCT/JP2009/060636
(87) International publication number: WO 2009/151085

(56) References cited:
- WO-A1-2007/069638
- WO-A1-2007/069638
- JP-A- 2002 145 622
- JP-A- 2004 255 684
- JP-A- 2006 199 556
- JP-A- 2006 199 556
- JP-B2- 3 513 589
- M. OSADA ET AL: "Gigantic Magneto-Optical Effects in Multilayer Assemblies of Two-Dimensional Titania Nanosheets", ADVANCED MATERIALS, vol. 18, no. 3, 3 February 2006 (2006-02-03), pages 295-299, XP055130990, ISSN: 0935-9648, DOI: 10.1002/adma.200501810

## Description

### [Technical Field]

The present invention relates to the use of a magnetic film in a transparent electromagnetic wave absorbent material which is applied to a broad field of information communication technology such as mobile telephones, wireless LANs, mobile electronic instruments and others and which exhibits favorable electromagnetic wave absorption performance.

### [Background Art]

Heretofore, electromagnetic waves are utilized in broadcasts, radars, ship communications, microwave ovens, etc.; and recently, with the noticeable development of information communication technology, their applications have become dramatically expanded. Above all, application of electromagnetic waves in the GHz band level that enable large-capacity information transmission is increasing abruptly, and such electromagnetic waves have become used in mobile telephones (1.5 GHz), ETC systems (5.8 GHz), satellite broadcasting (12 GHz), wireless LANs (2.45 to 60.0 GHz), in-car radars for preventing rear-end collision (76 GHz), etc.

Also in private households, ubiquitous society has started in which personal computers, televisions and other various information home appliances are networked with wireless communications using microwaves and millimeter waves in addition to existing cable wiring, thereby enabling anytime connection to computers.

In that manner, a lot of electromagnetic wave generation sources surround us, and with diversification of the application mode of electromagnetic waves in a high-frequency band, as combined with down-sizing, speeding-up and body-thinning of communication devices, the risk of unnecessary electromagnetic wave radiation and associated interference, malfunction and insufficiency of electronic parts is considered to increase markedly. With high-speed processing of digital instruments, the clock frequency is being higher at a speed of two times in 2 to 3 years and, as a result, the noise frequency is also being higher and higher, and has already been in a wide band of 5 GHz or so. In particular, in mobile electronic instruments such as notebook-size computers, mobile telephones and others, with the tendency toward higher frequency, higher density and higher integration of electronic devices, the electromagnetic wave interference inside the instruments is a serious problem; and it is now an important issue to remove the conductive noise in the GHz band that is superimposed as high harmonics on signals of a hundred to hundreds of MHz.

As one means of solving the electromagnetic wave noise in the GHz band, a method of using an electromagnetic wave absorber to absorb unnecessary electromagnetic waves, thereby preventing electromagnetic wave reflection and intrusion is effective. Of electromagnetic wave absorbers, magnetic material-based ones have the property of absorbing the energy of electromagnetic waves through magnetic resonance, and are therefore used as an electromagnetic wave absorbent material through the ages. Above all, Ni-Zn-based or Ni-Zn-Co-based ferrite magnetic substances have excellent electromagnetic wave absorption properties in the current high-frequency electromagnetic wave application band (0.1 to 15 GHz) for mobile telephones, wireless LANs and others, and an electromagnetic wave absorber produced by compounding such a ferrite magnetic substance with rubber or resin, and an electromagnetic wave absorbent film produced according to a sputtering method or a plating method have been developed. In fact, in the current mobile electronic instruments, an electromagnetic wave absorber that is referred to as a composite sheet where ferrite magnetic particles are dispersed in a resin is used, and a method of attaching the electromagnetic wave absorbent composite sheet to a print substrate to thereby remove the noise component in the GHz band superimposed on the conducting signal through the imaginary component (magnetic loss) of the magnetic permeability of the sheet is employed.

However, the electromagnetic wave absorbent material heretofore developed must have a thickness of at least from 0.05 to 0.1 mm or so for fully exhibiting the performance, and is therefore difficult to apply to further down-sized and integration-increased mobile instruments. In addition, existing ferrite-based electromagnetic wave absorbent materials could absorb electromagnetic waves only in a specific narrow frequency region, depending on the chemical composition of the powder and the thickness of the radiowave absorber; and those with versatility broadly applicable to different frequency bands are not as yet developed. Accordingly, electromagnetic wave absorbers having a chemical composition and a plate thickness intrinsic to the intended frequency must be prepared.

Further, with the recent rapid development of mobile telephones, wireless LANs and other mobile electronic instruments, radio interference brings about problems in various sites in medical practice, airliners, etc. In future, use of high-frequency band electromagnetic waves in transparent electronic devices such as large-sized liquid-crystal TVs, electronic papers and others is taken into consideration. With further development of electromagnetic wave application, it is desired to provide a transparent magnetic substance capable of being fused with a transparent medium such as glass or the like and capable of exhibiting stable electromagnetic wave absorption performance in different frequency bands.

On the other hand, as a transparent magnetic substance, a titania nanosheet substituted with a magnetic element such as cobalt, iron or the like has already been proposed (Patent Reference 1). Patent Reference 2 describes a magnetic artificial superlattice involving laminated thin films including two or more magnetic titanium nanosheets with Ti being substituted by magnetic elements. It has been confirmed that the titania nanosheet has excellent magneto-optical Faraday characteristics in a short wavelength region, and Non-Patent Reference 1 reports that the cobalt-substituted simple substance exhibits a gigantic magneto-optical effect of about 10,000 degree/cm in the ultraviolet region, and an ultra-lattice film composed of two types of a cobalt substitute and an iron substitute exhibits the effect of about 300,000 degree/cm.
[Patent Reference 1] JP-A 2006-199556
[Patent Reference 2] WO 2007/069638 A1
[Non-Patent Reference 1] Advanced Materials 18, 295-299 (2006).

### [Disclosure of the Invention]

### [Problems that the Invention is to Solve]

Under the background as above, the present invention is to provide a highly-versatile electromagnetic wave absorbent material which is transparent and which can stably exhibit electromagnetic wave absorption performance in different GHz bands

### [Means for Solving the Problems]

In one aspect the invention provides the use of a magnetic film comprising a titania nanosheet where a 3d magnetic metal element is substituted at the titanium lattice position and wherein the titania nanosheet is obtained by cleaving any of the phyllo-structured titanium oxides or their hydrates represented by the following compositional formula:

Compositional Formula: AₓTi_{1-y}M_{y}O₂

(wherein A is at least one selected from H, Li, Na, K, Rb and Cs; 0 < x ≤ 1; M is at least one selected from Cr, Mn, Fe, Co and Ni; 0 < y < 1), in an electromagnetic wave absorbent material exhibiting an electromagnetic absorption effect in a frequency range of 1 to 15 GHz.

The titania nanosheet may be a two-dimensional union of minimum constituent units, a titanium-oxygen octahedral block and a 3d magnetic metal element-oxygen octahedral block.

The magnetic film may contain a titania nanosheet and a binder.

The binder may be an organic polycation.

The magnetic film may be a laminate of a titania nanosheet and a binder.

The magnetic film may be formed on a substrate.

The thickness of the magnetic film may be from 10 nm to 10 µm.

### [Advantage of the Invention]

The invention has made it possible to develop an electromagnetic wave absorbent material taking advantage of the visible light transparency that a transparent magnetic substance has, and has made it possible to produce such an electromagnetic wave absorbent material from a safe, titanium oxide-based material at a low cost. Further, the invention has enabled precision control of the magnetic properties of the titania nanosheet and has therefore enabled production of a material having a high electromagnetic wave absorption effect in a GHz band and flexible control of the properties of the material.

When the titania nanosheet is a two-dimensional union of minimum constituent units, a titanium-oxygen octahedral block and a 3d magnetic metal element-oxygen octahedral block, the invention has made it possible to produce a material which utilizes a titania nanosheet having two-dimensional anisotropy, which therefore expresses magnetic resonance in a high-frequency region owing to the magnetic anisotropy caused by the morphology anisotropy thereof, and which exhibits a high electromagnetic wave absorption effect in a GHz band.

When the transparent magnetic substance contains a titania nanosheet and a binder the invention has realized in a simple manner with accuracy a magnetic film comprising a titania nanosheet, and has enabled its use as an electromagnetic wave absorbent device with various materials such as electromagnetic wave absorbent composite sheet, glass, semiconductor device and the like, favorable for application to various mobile electronic instruments such as mobile telephones, wireless LANs, etc.

When the non-magnetic polymer compound is an organic polycation, the invention has made it possible to plan and produce a high-quality electromagnetic wave absorbent film comprising a titania nanosheet, for devices having the intended thickness and electromagnetic wave absorption properties.

When the magnetic film is a laminate of a titania nanosheet and a binder the invention has provided a further accurate and high-quality magnetic film where a titania nanosheet and a binder are multilayered, and has realized an electromagnetic wave absorbent device excellent in electromagnetic wave absorbability.

When a magnetic film is formed on different substrates, and a highly-versatile electromagnetic wave absorbent material is thereby provided.

When the thickness of the magnetic film is from 10 nm to 10 µm, the invention has further realized electromagnetic wave absorption performance in the range of from 1 to 15 GHz band, and has therefore made it possible to develop a highly-versatile electromagnetic wave absorbent material capable of stably exhibiting electromagnetic wave absorption performance in different GHz bands and to apply it in a semi-microwave band (1 to 5 GHz) favorable for use in various mobile electronic instruments such as existing mobile telephones, wireless LANs, etc.

### [Brief Description of the Drawings]

[Fig. 1] Fig. 1 is a view graphically illustrating the cross-section structure of an electromagnetic wave absorber comprising a multilayer film of titania nanosheets in accordance with the invention.
[Fig. 2] Fig. 2 shows the UV-visible absorption spectrum and the optical photograph of the electromagnetic wave absorbent film of Example 1.
[Fig. 3] Fig. 3 is a graph showing the results of measurement of the electromagnetic wave absorption characteristics of the electromagnetic wave absorbent film of Example 1, according to a free space method.
[Fig. 4] Fig. 4 shows the UV-visible absorption spectrum and the optical photograph of the electromagnetic wave absorbent film of Example 2.
[Fig. 5] Fig. 5 is a graph showing the results of measurement of the electromagnetic wave absorption characteristics of the electromagnetic wave absorbent film of Example 2, according to a free space method.
[Fig. 6] Fig. 6 is a graph showing the results of measurement of the electromagnetic wave absorption characteristics of the electromagnetic wave absorbent film of Example 3, according to a free space method.

### [Description of Reference Numerals]

- 1: Substrate
- 2: Binder
- 3: Titania Nanosheet

### [Best Mode for Carrying out the Invention]

The invention is characterized by the above, and its embodiments are described below.

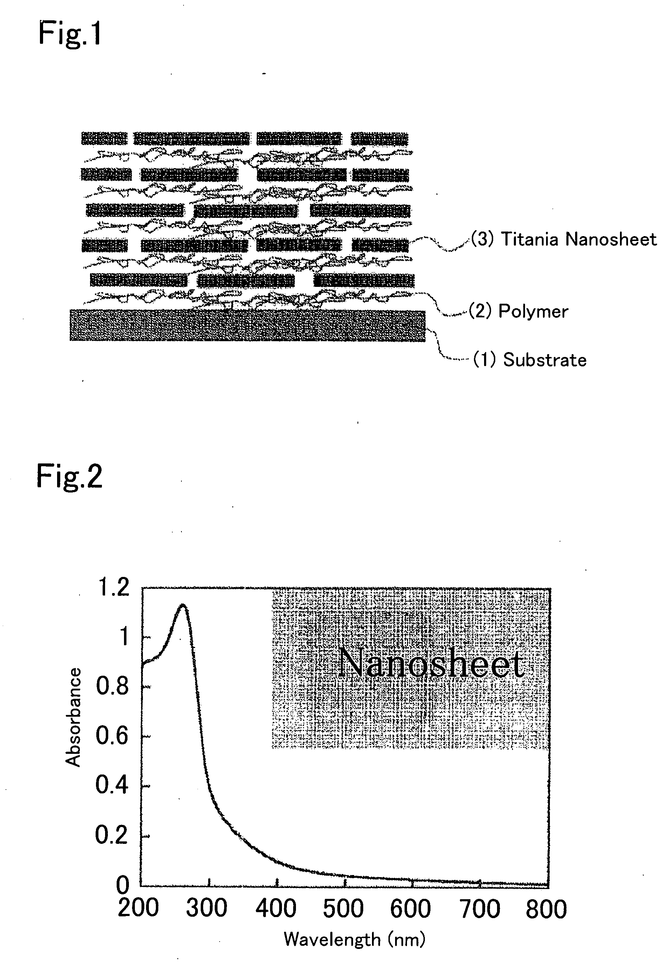

Fig. 1 is a view graphically illustrating the cross-section structure of an electromagnetic wave absorber comprising a multilayer film of titania nanosheets in accordance with one embodiment of the invention. In Fig. 1, (1) means a substrate composed of, for example, quartz glass; (2) means a binder such as a nonmagnetic polymer or the like formed on the substrate; (3) means a titania nanosheet constituting a magnetic film, in which a 3d magnetic metal element is substituted at the titanium lattice position (hereinafter this may be simply referred to as the titania nanosheet of the invention).

In the embodiment of Fig. 1, the titania nanosheets (3) are laminated via the binder (2) to constitute a magnetic film, as illustrated.

In the invention, the substrate (1) is not limited to, for example, quartz glass, but may be made of any other material such as metal electrodes of gold, platinum or the like, or Si substrates, plastics and others; and the titania sheets (3) may be arranged directly on the substrate.

The titania nanosheet (3) is a transparent magnetic substance having a sheet-like form, which may be prepared by soft chemical treatment of a phyllo-structured titanium compound in which a 3d magnetic metal element is substituted at the titanium lattice position, to thereby cleave it into every minimum layer unit of the crystal structure. A titania sheet not containing a 3d magnetic metal element could not exhibit magnetic properties, but substitution with a 3d magnetic metal element at the titanium lattice position therein could make the resulting sheet exhibit ferromagnetism.

Of the electromagnetic wave absorber in accordance with the invention, the main constituent, magnetic film comprises such titania nanosheets (3), in which, more preferably, the titania nanosheet (3) is a two-dimensional union of minimum constituent units, a titanium-oxygen octahedral block and a 3d magnetic metal element-oxygen octahedral block. Concretely, it is a sheet-like transparent magnetic substance having a thickness of about 1 nm (corresponding to a few atoms). In the field of application for electromagnetic wave absorbent materials, the titania nanosheets (3) having a larger width and a larger length and having higher-level anisotropy relative to the thickness thereof could be expected to have a more enhanced electromagnetic wave absorption potency; however, at present, particles having a large size of at least 100 µm are difficult to produce.

According to the present inventors' investigations, the width and the length could be controlled by controlling the heat treatment (firing) temperature of the starting, phyllo-structured titanium compound before cleaving it or by using a single crystal of the starting, phyllo-structured titanium compound; and it is possible to produce the titania nanosheet (3) of which the width and the length are controlled to fall within a range of from 100 nm to 100 µm. Even such nanosheets having different width and length could have the specific property of continuously and stably absorbing electromagnetic waves in a broad frequency region, and therefore a versatile electromagnetic wave absorber can be constructed here.

The titania nanosheet (3) can be prepared from a phyllo-structured titanium oxide where a 3d magnetic metal element is substituted at the titanium lattice position, by monolayer cleavage thereof into every layer of the constitutive unit. In this case, the titania nanosheet (3) may be any one in which a 3d magnetic metal element is substituted at the titanium lattice position and which therefore exhibits magnetic properties; and for this, mentioned is the compositional formula Ti_{1-y}M_{y}O₂ (wherein M is at least one selected from magnetic elements selected from Cr, Mn, Fe, Co and Ni; and 0 < y < 1). Concretely, there may be mentioned compositional formulae of Ti_{0.8}Co_{0.2}O₂, Ti_{0.75}Co_{0.15}Fe_{0.1}O₂, etc.

The treatment for monolayer cleavage is referred to as soft chemical treatment, and the soft chemical treatment is a combined treatment of acid treatment and colloidalization treatment. Specifically, a phyllo-structured titanium oxide powder is contacted with an aqueous acid solution such as hydrochloric acid solution or the like, and the product is collected through filtration, washed and dried, whereby the alkali metal ions having existed between the layers before the treatment are all substituted with hydrogen ions to give a hydrogen-type substance. Next, the obtained hydrogen-type substance is put into an aqueous solution of an amine or the like and stirred therein, which is thus colloidalized. In this process, the layers having formed the phyllo-structure (concretely, a two-dimensional union of the minimum constituent units, titanium-oxygen octahedral block and 3d magnetic metal element-oxygen octahedral block) are cleaved into the individual layers. The thickness of each layer may be controlled within a range of from sub nm to nm.

The electromagnetic wave absorbent material of the invention could function as an electromagnetic wave absorber by filmwise shaping the packed structure of titania nanosheets into a magnetic film. The packed structure as referred to herein is meant to indicate that the nanosheets are contacted with each other or are kept adjacent to each other, thereby forming a three-dimensional structure, but is not a term to indicate close packing. For practical use as an electromagnetic wave absorber, the magnetic film must have the packed structure. For the method, there may be mentioned a method of using a binder to bind and fix the individual titania nanosheets to thereby constitute a film-like packed structure.

Concretely, the titania sheets (3) of the invention may be applied onto the surface of the substrate (1) or the like, using a nonmagnetic polymer or the like as the binder (2), thereby constructing an electromagnetic wave absorber where the packed structure is kept as such therein. For producing such a film-like electromagnetic wave absorber, herein employable are embodiments that are laminated according to the alternate self-organization lamination technology (Patent Reference 2, Patent Reference 3) which the present inventors have previously proposed.
Patent Reference 2: JP-A 2001-270022
Patent Reference 3: JP-A 2004-255684

In an actual process, a series of operations, [1] dipping a substrate in a binder solution → [2] washing it with pure water → [3] dipping it in a titania nanosheet sol solution → [4] washing it with pure water, as one cycle, are repeated for necessary times; and according to the process, the binder and the titania nanosheets can be alternately laminated.

The binder may be suitably selected from nonmagnetic ones in accordance with the production method and the desired properties thereof. Concretely, for example, nonmagnetic polymer compounds may be used, and as their suitable examples, there may be mentioned organic polycations such as polydiallyldimethylammonium chloride (PDDA) described in Examples or the like, as well as organic polymers having similar cationic properties such as polyethyleneimine (PEI), polyallylamine hydrochloride (PAH), etc. Further, not limited to organic polymers, nonmagnetic inorganic compounds are also usable. For example, in alternate lamination, the binder may be any one with no problem that can have positive charges introduced into the surface thereof, for adsorbing and fixing the minus-charged titanium nanosheets thereon; and therefore, in place of organic polymers, also usable are inorganic polymers having positive charges, and inorganic compounds containing polynuclear hydroxide ions.

In film formation through alternate lamination, the surface of the substrate (1) may be good to well adsorb the nanosheets (3) or the polymer so as to be fully coated with them; and in place of the alternate self-organization lamination technology, a spin coating method or a dip coating method may also be employable here.

The thickness of the magnetic film in the electromagnetic wave absorber depends on the frequency band of the electromagnetic waves to be absorbed by the absorber, and for stably absorbing the waves in a range of from 1 to 15 GHz band, the thickness may be reasonably at least 10 nm, preferably at least 14 nm, more preferably at least 70 nm. Its uppermost limit may be at most 10 µm, more preferably at most 5 µm, even more preferably at most 2 µm. When too thick, the electromagnetic wave absorbent material would bring about a problem in that its optical transparency within a visible light range may lower.

The electromagnetic wave absorbent material thus prepared has high-level lamination regularity and, for example, shows definite X-ray diffraction peaks based on the recurring period of titania nanosheets and PDDA. In this case, in fact, when the process of forming a multilayer film of titania nanosheets and PDDA was monitored through X-ray diffractiometry, then Bragg peaks indicating the periodic structure of around 1.4 nm appeared, and with the increase in the adsorption frequency, the intensity increased. Specifically, the nanosheets and PDDA adsorbed and accumulated in order are not disordered after the film formation, and are shown to keep an orderly multilayer nanostructure. As a method of more directly monitoring the film formation process, there may be mentioned measurement of the film thickness through UV-visible absorptiometry or ellipsometry. From this, step-by-step increase in the film thickness in every adsorption operation could be read within a range of from sub nm to µm. Accordingly, the film thickness can be controlled in such an extremely microscopic region.

As described in the above, in the invention, a titania nanosheet and a binder such as an organic polycation or the like are separately adsorbed from the respective liquid phases as a monolayer in a mode of self-organization, and the process is repeated for film formation; and therefore, the film formation process of the invention is characterized in that extremely microscopic film thickness control in a range of from sub nm to nm is possible therein and that the latitude in selecting and controlling the film composition and structure is broad. In particular, the film thickness accuracy of the multilayer ultra-thin film comprising titania nanosheets and a binder such as an organic polycation or the like is at most 1 nm, and therefore depending on the adsorption cycle repetition frequency, the final film thickness can be increased up to the level of µm.

In the invention, for example, according to the production method including at least a part of the above-mentioned step, an electromagnetic wave absorber can be realized. For example, in the embodiments shown in the following Examples, titania nanosheets are formed, starting from a phyllo-structured titanium oxide, and as shown in Fig. 1, a multilayer film is formed on a quartz glass substrate according to alternate self-organization lamination technique or a spin coating method. Needless-to-say, the invention is not limited by the following Examples.

When the electromagnetic wave absorbing titania nanosheets in the invention are kneaded with a nonmagnetic polymer base serving as a binder to prepare a kneaded mixture and when the mixture is applied onto the surface of a substrate or the like, then an electromagnetic wave absorber keeping the packed structure therein can be constructed. In this case, the amount of the electromagnetic wave absorbing titania nanosheets in the mixture is preferably at least 60% by mass.

In case where titania nanosheets are dispersed in a kneaded mixture in the manner as above, various types of polymer bases satisfying heat resistance, flame retardancy, durability, mechanical strength and electric properties may be used as the binder, depending on the environment of usage. For example, suitable ones may be selected from resins (nylon, etc.), gels (silicone gel, etc.), thermoplastic elastomers, rubbers, etc. Two or more different types of polymer compounds may be blended for use as the base, and gelatin or the like may be added for increasing the viscosity. Further, for improving the compatibility and dispersibility with the polymer base, various additives such as plasticizer, reinforcing agent, heat resistance improver, thermal conductive filler, tackifier and the like may be added in blending the electromagnetic wave absorbing material mixture and the polymer base.

The above-mentioned kneaded mixture may be rolled into a sheet having a predetermined sheet thickness, thereby giving an electromagnetic wave absorber which keeps the above-mentioned packed structure and which comprises a magnetic film as the main constituent thereof. In place of rolling, the kneaded mixture may be injection-molded to give an electromagnetic wave absorber having a desired shape.

### <Example 1>

In this Example, starting from a phyllo-structured titanium oxide (for example, K_{0.4}Ti_{0.8}Co_{0.2}O₂), a transparent magnetic substance (3) comprising titania nanosheets (Ti_{0.8}Co_{0.2}O₂) is formed, and as shown in Fig. 1, the titania nanosheets (3) and a cationic polymer (2) polydiallyldimethylammonium chloride (PDDA) are alternately laminated on a quartz glass substrate (1) to form a magnetic film thereon in the manner mentioned below, thereby producing an electromagnetic wave absorbent film.

Phyllo-structured titanium oxide (K_{0.4}Ti_{0.8}Co_{0.2}O₂) was prepared by mixing potassium carbonate (K₂CO₃), titanium oxide (TiO₂) and cobalt oxide (CoO) in a ratio K/Ti/Co of 4/4/1, and then firing it at 800°C for 40 hours.

One g of the powder was acid-treated in 100 mL of aqueous 1 N hydrochloric acid solution at room temperature to give a hydrogen-exchanged form (H_{0.4}Ti_{0.8}Co_{0.2}O₂). Next, 100 mL of an aqueous solution of tetrabutylammonium hydroxide (hereinafter this is referred to as TBAOH) was added to 0.5 g of the hydrogen-exchanged form and reacted with stirring at room temperature for 1 week, thereby producing a sol solution of, as dispersed therein, rectangular nanosheets (3) represented by a compositional formula Ti_{0.8}Co_{0.2}O₂ and having a thickness of about 1 nm and a width and a length (hereinafter this is referred to as a lateral size) of from 1 to 10 µm. Further this was diluted 50-fold to prepare a diluted solution.

A quartz glass substrate (1) was washed on the surface thereof through UV irradiation in an ozone atmosphere, then dipped in a solution of hydrochloric acid/methanol = 1/1 for 1/3 hours, and in concentrated sulfuric acid for 1/3 hours for hydrophilication treatment.

The substrate (1) was repeatedly processed for a series of operations as one cycle mentioned below, for a total of the necessary cycles, thereby forming a titania nanosheet thin film having a thickness necessary for the desired electromagnetic wave absorbent film.
[1] Dipping in the above-mentioned PDDA solution for 1/3 hours.
[2] Washing fully with Milli-Q pure water.
[3] Dipping in the above-mentioned nanosheet sol solution with stirring.
[4] After 1/3 hours, washing fully with Milli-Q pure water.

Fig. 2 shows the UV-visible absorption spectrum and the optical photograph of the thus-obtained electromagnetic wave absorbent film having a film thickness of 14 nm in which Ti_{0.8}Co_{0.2}O₂ titania nanosheets and PDDA are alternately laminated to form 10 layers. The electromagnetic wave absorbent film comprising titania nanosheets has a broad band gap (300 nm) based on the quantum size effect, and the sample formed on the quartz glass substrate has, as shown in Fig. 2, an absorbance of at most 0.15 at a wavelength of 350 nm or more and is transparent in a broad region of the visible light range.

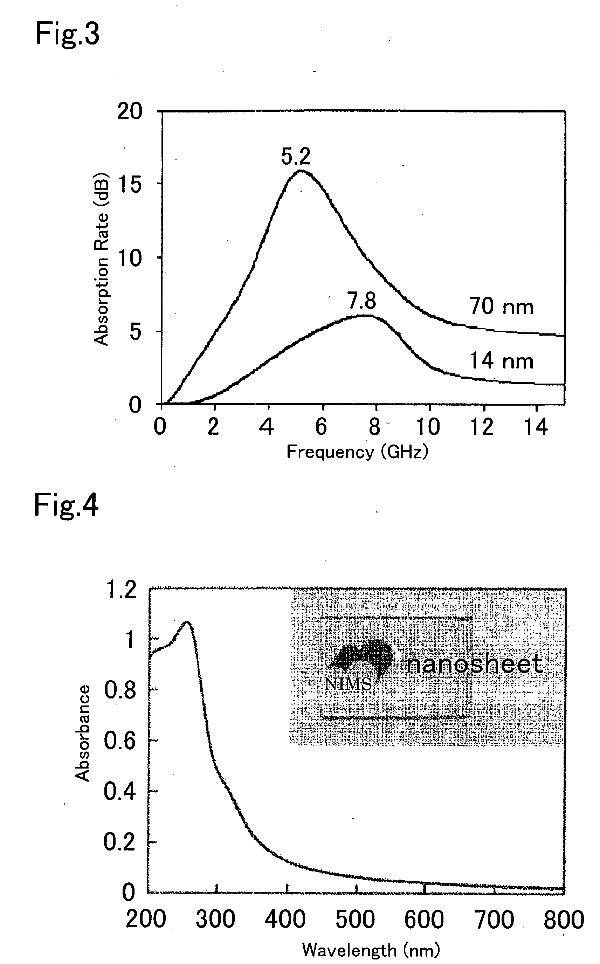

Next, electromagnetic wave absorbent films having a film thickness of 14 nm and 70 nm produced similarly were analyzed for the electromagnetic wave absorption property thereof according to a free space method. The free space method is a method where a test sample is put in a free space and irradiated with plane waves, and its S parameter is measured to thereby determine the electromagnetic wave absorption property of the sample. The electromagnetic wave absorbent film is shaped into a ring sample having an outer diameter φ 6.9 mm and an inner diameter φ 3.1 mm, and using quartz glass and epoxy resin, this is formed into a disc-shaped packed structure having a size of outer diameter φ 6.9 mm × thickness 10 mm. The electromagnetic wave absorbent sample of the packed structure is put at the center between a sending antenna and a receiving antenna, electromagnetic waves are radiated vertically to the sample, and the reflected wave and the transmitted wave (that is, reflection coefficient S₁₁ and transmission coefficient S₂₁) are measured. With that, the energy absorption is computed as 1-|S₁₁|²-|S₂₁|², and this is expressed as the electromagnetic wave absorption rate (dB). The measurement is effected in the range of from 0.01 to 15 GHz band. The results are shown in Fig. 3.

Fig. 3 confirms that the electromagnetic wave absorbent sample has, though it is an extremely thin film, an absorption rate of 1 dB at 2.3 GHz and an absorption rate of 1.7 dB at 12 GHz around the center of 7.8 GHz, or that is, the absorbent sample secures stable electromagnetic wave absorption in the range of from 2.3 to 12 GHz band. When the film thickness is increased from 14 nm to 70 nm, the magnetic resonance frequency is shifted to the low frequency side around 5.2 GHz, and at 1 GHz, the absorption rate is 2.3 dB, and at 15 GHz, the absorption rate is 4.8 dB, or that is, the invention has made it possible to produce a material having a high electromagnetic wave absorption effect in a range of from 1 to 15 GHz band.

### <Example 2>

In this Example, starting from a phyllo-structured titanium oxide (K_{0.4}Ti_{0.75}Co_{0.15}Fe_{0.1}O₂) in which Co and Fe were substituted at the titanium lattice position, a transparent magnetic film comprising titania nanosheets (Ti_{0.75}Co_{0.15}Fe_{0.1}O₂) was formed, thereby producing an electromagnetic wave absorbent film of the above-mentioned titania nanosheets (3) and a binder (2) PDDA alternately laminated on a quartz substrate.

Phyllo-structured titanium oxide (K_{0.4}Ti_{0.75}Co_{0.15}Fe_{0.1}O₂) was prepared by mixing potassium carbonate (K₂CO₃), titanium oxide (TiO₂), cobalt oxide (CoO) and iron oxide (Fe₂O₃) in a ratio K/Ti/Co/Fe of 0.8/0.75/0.15/0.1, and then firing it at 800°C for 40 hours.

One g of the powder was acid-treated in 100 mL of aqueous 1 N hydrochloric acid solution at room temperature to give a hydrogen-exchanged form (H_{0.4}Ti_{0.75}Co_{0.15}Fe_{0.1}O₂). Next, 100 mL of an aqueous TBAOH solution was added to 0.5 g of the hydrogen-exchanged form and reacted with stirring at room temperature for 1 week, thereby producing a sol solution of, as dispersed therein, rectangular nanosheets (3) represented by a compositional formula Ti_{0.75}Co_{0.15}Fe_{0.1}O₂ and having a thickness of about 1 nm and a lateral size of from 1 to 10 µm. Further this was diluted 50-fold to prepare a diluted solution.

Using the thus-obtained titania nanosheets and according to the same alternate absorption method as in Example 1, the titania nanosheets and PDDA were alternately laminated on a quartz glass substrate to form a magnetic film thereon, thereby producing an electromagnetic wave absorbent film.

Fig. 4 shows the UV-visible absorption spectrum and the optical photograph of the thus-obtained electromagnetic wave absorbent film having a film thickness of 14 nm in which Ti_{0.75}Co_{0.15}Fe_{0.1}O₂ titania nanosheets and PDDA are alternately laminated to form 10 layers. The electromagnetic wave absorbent film comprising titania nanosheets has a broad band gap (300 nm) based on the quantum size effect, and the sample formed on the quartz glass substrate has, as shown in Fig. 4, an absorbance of at most 0.2 at a wavelength of 350 nm or more and is transparent in a broad region of the visible light range.

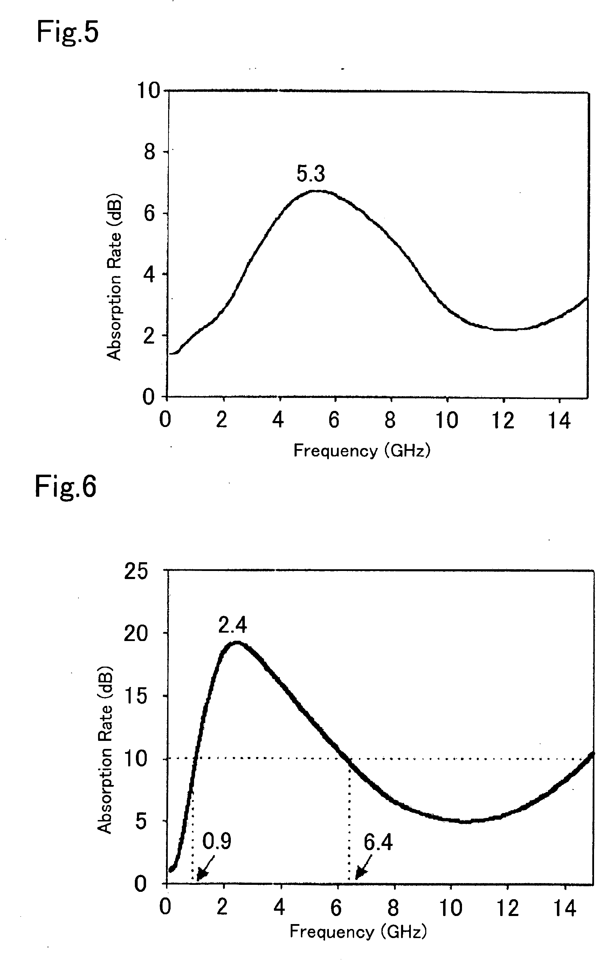

Fig. 5 shows the result of the measurement of the electromagnetic wave absorption property of the electromagnetic wave absorbent film comprising the alternate laminate of Ti_{0.75}Co_{0.15}Fe_{0.1}O₂ titania nanosheets and PDDA, according to the free space method as in Example 1. Fig. 5 confirms that the electromagnetic wave absorbent sample has, though it is an extremely thin film having a thickness of 14 nm, an absorption rate of 1.3 dB at 0.1 GHz and an absorption rate of 2.2 dB at 12 GHz around the center of 5.3 GHz, or that is, the absorbent sample secures stable electromagnetic wave absorption in the range of from 0.1 to 15 GHz band.

Further, the titania nanosheet substituted with both Co and Fe in this Example exhibited the electromagnetic wave absorption effect higher by from 1.5 to 3 times in the range of from 2 to 10 GHz band, than that of the titania nanosheets substituted with Co alone in Example 1. This is because, in the nanosheets containing different magnetic elements both at high concentrations in one and the same nanosheet, there occurs a strong electron/spin interaction between the different magnetic elements inside the two-dimensional structure, which, however, could not be realized in the structure with Co alone, and therefore, the magnetic susceptibility in the nanosheets has increased.

At present, use of the binder as in Examples 1 and 2 can enhance the film quality of the magnetic films produced, and therefore, the absorbers thus produced could have good electromagnetic wave absorption properties.

### <Example 3>

In this Example, the transparent magnetic substance comprising the titania nanosheets (Ti_{0.75}Co_{0.15}Fe_{0.1}O₂) produced in Example 2 was used, and according to a spin coating method, an electromagnetic wave absorbent film having a thickness of a few µm was produced.

Starting from phyllo-structured titanium oxide (K_{0.4}Ti_{0.75}Co_{0.15}Fe_{0.1}O₂) where Co and Fe were substituted at the titanium lattice position, and according to the same method as in Example 2, a sol solution of, as dispersed therein, rectangular nanosheets (3) represented by a compositional formula Ti_{0.75}Co_{0.15}Fe_{0.1}O₂ and having a thickness of about 1 nm and a lateral size of from 1 to 10 µm was produced.

Next, 20 mL of a spin-coating gelatin dispersant was added to 100 mL of the nanosheet dispersion, and stirred at room temperature to prepare a nanosheet solution.

Using the nanosheet mixture solution and repeating a series of operations mentioned below as one cycle, for a total of the necessary cycles, an electromagnetic wave absorbent film was formed, as provided with a magnetic film having a desired film thickness on a quartz glass substrate.
[1] Dropwise adding the nanosheet solution to the substrate.
[2] Uniformly applying the solution to the substrate surface according to a spin coating method.
[3] Drying at room temperature under reflux of dry air gas.

Fig. 6 shows the result of the measurement of the electromagnetic wave absorption property of the thus-obtained electromagnetic wave absorbent film comprising Ti_{0.75}Co_{0.15}Fe_{0.1}O₂ titania nanosheets and having a film thickness of 2 µm (in which the number of the laminated nanosheets would be at least 500), according to the free space method as in Example 1. Fig. 6 confirms that the electromagnetic wave absorbent sample has an absorption rate of 1.08 dB at 0.01 GHz, an absorption rate of 10 dB at 0.9 GHz and at 6.4 GHz, and an absorption rate of 5.1 dB at 10.5 GHz around the center of 2.4 GHz, or that is, the absorbent sample secures stable electromagnetic wave absorption in the range of from 0.01 to 15 GHz band. Further, as compared with that of the electromagnetic wave absorbent sample having a thickness of 14 nm in Example 2, the magnetic resonance frequency of the electromagnetic wave absorbent sample having a thickness of 2 µm of this Example is shifted toward the low frequency side; and the present invention has made it possible to produce a material capable of exhibiting a high electromagnetic wave absorption effect of at least 10 dB especially in a region of from 0.9 to 6.4 GHz band. Regarding existing electromagnetic wave absorbers, the absorption band region thereof varies with the increase in the thickness thereof, and therefore the applicable absorption band range is limited; however, the electromagnetic wave absorbent samples in accordance with the present invention maintained specific electromagnetic wave absorption behavior in that even when the thickness thereof is varied, the absorbers secures stable electromagnetic wave absorption in a broad frequency band region.

### [Industrial Applicability]

As described in the above, the present invention has made it possible to produce an electromagnetic wave absorber capable of stably and continuously exhibiting its electromagnetic wave absorption performance in a region of from 1 to 15 GHz band and has made it possible to freely control the properties of the absorber, taking advantage of the specific electromagnetic wave absorption property that the titania nanosheets therein have.

At present, ferrite-based materials put into practical use as electromagnetic wave absorbers must have a thickness of at least from 0.05 to 0.1 mm or so in order to exhibit a sufficient electromagnetic wave absorbing effect; however, the electromagnetic wave absorber of the invention can function even though its thickness is 2 µm or less. In particular, the frequency for electromagnetic wave absorption by existing electromagnetic wave absorbers perceptively varies depending on the thickness of the absorbers; however, not depending on the thickness thereof, the electromagnetic wave absorber of the invention secures stable electromagnetic wave absorption in a broad frequency region, and it maintains such a specific electromagnetic wave absorption behavior. Accordingly, the electromagnetic wave absorber in accordance with the invention is applicable to further down-sized and integration-increased mobile instruments.

With the recent rapid development of mobile telephones, wireless LANs and other mobile electronic instruments, radio interference brings about problems in various sites in medical practice, airliners, etc. The electromagnetic wave absorber in accordance with the invention is formed of a transparent material and realizes excellent electromagnetic wave absorption properties; and therefore, it can be fused with a transparent medium such as windowpane or the like and is applicable to transparent electronic devices such as large-size liquid-crystal TVs, electronic papers others, though existing materials could not do so.

Further, the electromagnetic wave absorber in accordance with the invention can be produced according to a low-cost, low environmental-load process not requiring any expensive film formation apparatus that is the mainstream for existing electromagnetic wave absorbers. Accordingly, it is concluded that the electromagnetic wave absorber of the invention is extremely useful when used in a broad filed of information communication technology such as mobile telephones, wireless LANs and other mobile electronic instruments.

## Claims

1. The use of a magnetic film comprising a titania nanosheet where a 3d magnetic metal element is substituted at the titanium lattice position and wherein the titania nanosheet is obtained by cleaving any of the phyllo-structured titanium oxides or their hydrates represented by the following compositional formula:
Compositional Formula: AₓTi_{1-y}M_{y}O₂
(wherein A is at least one selected from H, Li, Na, K, Rb and Cs; 0 < x ≤ 1; M is at least one selected from Cr, Mn, Fe, Co and Ni; 0 < y < 1), in an electromagnetic wave absorbent material exhibiting an electromagnetic absorption effect in a frequency range of 1 to 15 GHz.

2. The use as claimed in claim 1, wherein the titania nanosheet is a two-dimensional union of minimum constituent units, a titanium-oxygen octahedral block and a 3d magnetic metal element-oxygen octahedral block.

3. The use as claimed in claim 1 or claim 2, wherein the magnetic film contains the titania nanosheet and a binder.

4. The use as claimed in claim 3, wherein the binder is an organic polycation.

5. The use as claimed in claim 3 or 4, wherein the magnetic film is a laminate of a titania nanosheet and a binder.

6. The use as claimed in any of claims 3 to 5, wherein the magnetic film is formed on a substrate.

7. The use as claimed in any of claims 1 to 6, wherein the thickness of the magnetic film is from 10 nm to 10 µm.

## Patentansprüche

1. Verwendung eines Magnetfilms umfassend eine Titandioxidnanoplatte, wobei ein magnetisches 3-D-Metallelement an der Titangitterposition substituiert ist und wobei die Titandioxidnanoplatte durch Spalten irgendeines der phyllostrukturierten Titanoxide oder ihrer Hydrate erhalten wird, die durch die folgende Zusammensetzungsformel dargestellt sind:
Zusammensetzungsformel: AₓTi_{1-y}M_{y}O₂
(wobei A mindestens eines ist ausgewählt unter H, Li, Na, K, Rb und Cs; 0 < x ≤ 1; M mindestens eines ist ausgewählt unter Cr, Mn, Fe, Co und Ni; 0 < y < 1) in einem elektromagnetische Wellen absorbierenden Material, das eine elektromagnetische Absorptionswirkung in einem Frequenzbereich von 1 bis 15 GHz aufweist.

2. Verwendung nach Anspruch 1, wobei die Titandioxidnanoplatte eine zweidimensionale Vereinigung von konstituierenden Mindesteinheiten, einem oktaedrischen Titan-Sauerstoffblock und einem magnetischen oktaedrischen 3D-Metallelement-Sauerstoff-Block ist.

3. Verwendung nach Anspruch 1 oder Anspruch 2, wobei der Magnetfilm die Titandioxidnanoplatte und ein Bindemittel enthält.

4. Verwendung nach Anspruch 3, wobei das Bindemittel ein organisches Polykation ist.

5. Verwendung nach Anspruch 3 oder 4, wobei der Magnetfilm ein Laminat einer Titandioxidnanoplatte und eines Bindemittels ist.

6. Verwendung nach einem der Ansprüche 3 bis 5, wobei der Magnetfilm auf einem Substrat gebildet wird.

7. Verwendung nach irgendeinem der Ansprüche 1 bis 6, wobei die Dicke des Magnetfilms 10 nm bis 10 µm beträgt.

## Revendications

1. Utilisation d'un film magnétique comprenant une nanofeuille de dioxyde de titane où un élément métallique magnétique 3D est substitué au niveau de la position du titane dans le réseau et dans laquelle la nanofeuille de dioxyde de titane est obtenue par clivage de l'un quelconque des oxydes de titane à structure feuilletée ou de leurs hydrates représentés par la formule compositionnelle suivante :
Formule compositionnelle : AₓTi_{1-y}M_{y}O₂
(dans laquelle A est au moins un choisi parmi H, Li, Na, K, Rb et Cs ; 0 < x ≤ 1 ; M est au moins un choisi parmi Cr, Mn, Fe, Co et Ni ; 0 < y < 1), dans un matériau absorbant d'ondes électromagnétiques présentant un effet d'absorption électromagnétique dans une plage de fréquence de 1 à 15 GHz.

2. Utilisation selon la revendication 1, dans laquelle la nanofeuille de dioxyde de titane est une union bidimensionnelle d'unités constitutives minimales, un bloc octaédrique titane-oxygène et un bloc octaédrique élément métallique magnétique 3d-oxygène.

3. Utilisation selon la revendication 1 ou la revendication 2, dans laquelle le film magnétique contient la nanofeuille de dioxyde de titane et un liant.

4. Utilisation selon la revendication 3, dans laquelle le liant est un polycation organique.

5. Utilisation selon la revendication 3 ou 4, dans laquelle le film magnétique est un stratifié d'une nanofeuille de dioxyde de titane et d'un liant.

6. Utilisation selon l'une quelconque des revendications 3 à 5, dans laquelle le film magnétique est formé sur un substrat.

7. Utilisation selon l'une quelconque des revendications 1 à 6, dans laquelle l'épaisseur du film magnétique est de 10 nm à 10 µm.
